# EUROPÄISCHE PATENTSCHRIFT

(11) **EP 4 024 398 B1**
(45) Veröffentlichungstag und Bekanntmachung des Hinweises auf die Patenterteilung: **20.08.2025**
(21) Anmeldenummer: 21217897.4
(22) Anmeldetag: 28.12.2021
(51) Int. Cl.: G11C 29/32

(54) **FEHLERTOLERANTE SEQUENZIELLE SPEICHERZELLE UND TESTVERFAHREN FÜR DIE SPEICHERZELLE**
FAULT-TOLERANT SEQUENTIAL MEMORY CELL AND TEST METHOD FOR THE MEMORY CELL
CELLULE MÉMOIRE SÉQUENTIELLE TOLÉRANTE AUX DÉFAILLANCES ET PROCÉDÉ D'ESSAI POUR LA CELLULE MÉMOIRE

(30) Priorität: 30.12.2020 DE 102020135080; 29.03.2021 DE 102021107879
(43) Veröffentlichungstag der Anmeldung: 06.07.2022
(73) Patentinhaber: IHP GmbH - Innovations for High Performance Microelectronics / Leibniz-Institut für innovative Mikroelektronik, 15236 Frankfurt (Oder) (DE)
(72) Erfinder: Zeidler, Steffen, 15236 Frankfurt (Oder) (DE); Schrape, Oliver, 15236 Frankfurt (Oder) (DE); Breitenreiter, Anselm, 15236 Frankfurt (Oder) (DE); Krstic, Milos, 15236 Frankfurt (Oder) (DE)
(74) Vertreter: Eisenführ Speiser

(56) Entgegenhaltungen:
- JP-A- 2019 191 064
- US-A1- 2002 074 609
- US-A1- 2007 262 787
- US-A1- 2011 022 908
- US-A1- 2011 022 909
- US-A1- 2013 339 819
- ROYSTEIN OLIVEIRA ET AL: "A TMR Scheme for SEU Mitigation in Scan Flip-Flops", QUALITY ELECTRONIC DESIGN, 2007. ISQED '07. 8TH INTERNATIONAL SYM POSIUM ON, IEEE, PI, 1 March 2007 (2007-03-01), pages 905 - 910, XP031074151, ISBN: 978-0-7695-2795-6

## Beschreibung

### Gebiet

Die vorliegende Erfindung betrifft eine Speicherschaltung, insbesondere eine sequenzielle scanbare Speicherzelle, die auf Basis von Triple-Modular-Redundancy (TMR) fehlertolerant ist. Außerdem betrifft die Erfindung ein Verfahren, das es gestattet, ein Testmuster zu erzeugen, mit dem interne Bitfehler in der Speicherschaltung detektierbar sind.

### Hintergrund der Erfindung

Es ist bekannt, dass beim Betrieb von integrierten Schaltungen mitunter sogenannte Single-Event-Effekte (SEE) auftreten, die durch hochenergetische Strahlung ionisierender Teilchen, darunter z.B. geladene Teilchen oder Partikel, hervorgerufen werden können. Oft können solche Strahlungen in bestimmten Umgebungen, wie z.B. im Weltraum, in Kernreaktoren oder in Luftfahrzeugen, nicht vollständig abgeschirmt werden.

Bei SEEs unterscheidet man zwischen dauerhaften Schäden ("hard errors") und solchen, die nur zu einem vorübergehenden Wechsel einer Signalinformation führen ("soft errors"). Zu den sogenannten "hard errors" zählt z.B. Single-Event Latchup, der in einen kompletten Kurzschluss des Systems resultiert. Darüber hinaus versteht man unter einem Single-Event Burnout die strukturelle Beschädigung einer Schaltung, die zu einer permanenten Fehlfunktion oder zum vollständigen Systemausfall führen kann. Die bekanntesten soft errors sind Single-Event Upsets (SEU) und Single-Event Transients (SET). Bei letzterem entsteht durch induzierte Ladung in Abhängigkeit der Ladungsmenge ein Spannungspuls, der durch die Logik propagiert und somit nur temporär zu Fehlern führt. Ein SEU kann hingegen durch einen direkten Treffer eines hoch-energetischen Teilchens zu einem direkten Kippen (bit-flip) der Bitinformation in sogenannten Verriegelungsschaltungen wie Latches oder Flip-Flops führen. Des Weiteren, kann ein Transient auch zu einem Upset führen, wenn dieser mit der sensitiven Taktflanke oder Pulsbreite von einem Flip-Flop (FF) übernommen oder von einem Latch fälschlicherweise gehalten wird.

Um durch SEUs verursachte Fehlfunktionen zu verhindern bzw. deren Wirkung abzuschwächen, werden in Schaltungen Maßnahmen angewandt, bei denen in der Regel durch eingebaute Redundanz Fehler korrigiert werden können. Ein solches oft angewandtes Verfahren ist das TMR-Design, bei dem die sensitiven Komponenten einer Schaltung verdreifacht (repliziert) werden. Eine Auswahlschaltung (ein sogenannter Voter, Mehrheitsentscheids- oder auch Majoritätsgatter) führt im Anschluss einen Mehrheitsentscheidung auf Basis der berechneten Ergebnisse der drei Replikate durch. Das TMR-Verfahren kann auf verschiedenen Ebenen angesetzt werden. So können z.B. entweder ganze Systeme, Schaltungsblöcke oder aber einzelne Schaltungselemente vervielfältigt und durch TMR fehlertolerant entworfen werden. In der hier beschriebenen Erfindung wird TMR auf Schaltungsebene eingesetzt, um einzelne sequentielle Speicherzellen in Gestalt von sogenannten Flip-Flops oder Latches fehlertolerant zu gestalten. Dadurch ist es möglich einen 1-BitFehler durch TMR zu korrigieren. Ferner sind Maßnahmen für die Robustheit gegenüber SEEs und der Testbarkeit der Speicherzelle getroffen worden. Solche sequenziellen Speicherzellen werden beispielsweise in hoch zuverlässigen Schaltungen für Anwendungen in der Luft- und Raumfahrt oder der Automobilindustrie eingesetzt

Eine elektronische Schaltung mit einer sequentiellen Logikschaltung und einer der sequentiellen Logikschaltung nachgeschalteten Auswahlschaltung ist aus der DE 10 2006 055 867 A1 bekannt. Die Voterschaltung wird dort in Verbindung mit einem TMR-Design verwendet. Die Schaltung weist drei parallele Speicherelemente auf, die nominell identische Eingangssignale erhalten, die den erwähnten drei Ausführungen des digitalen Signals entsprechen. Der Voter erhält die Ausgangssignale von den drei parallelen Speicherelementen als Eingangssignale und erzeugt ein Ausgangssignal, das einer Mehrheit der drei Eingangssignale entspricht. Folglich ist im Normalbetrieb das Ausgangssignal der Speicherelemente identisch. Tritt jedoch innerhalb einer Speicherzelle ein SEU auf, wird dessen Inhalt gestört, d.h. es schaltet von 1 auf 0 oder umgekehrt. Das Ausgangssignal des Voters wird dadurch jedoch nicht beeinflusst, da die beiden anderen Speicherelemente weiterhin den korrekten Wert ausgeben. Auf diese Weise schützt der Voter die elektronische Schaltung vor der Ausgabe von Signalen, die durch ein SEU verfälscht werden.

Die fehlerkorrigierenden Eigenschaften einer solchen TMR Speicherzelle bringt jedoch den Nachteil mit sich, dass ein Fehler innerhalb der Zelle, der zum Beispiel durch einen Produktionsdefekt verursacht ist, nicht an deren Ausgang erkannt werden kann, weil der Voter das Ergebnis korrigiert. Liegt zum Beispiel innerhalb der TMR Speicherzelle am Ausgang eines FFs ein Haftfehler mit dem Wert 0 an, während die beiden anderen FFs zweimal den richtigen Wert 1 speichern, dann gibt die TMR Speicherzelle dennoch das richtige Ausgangssignal 1 aus. Tritt nun im praktischen Einsatz zusätzlich ein SEE auf, der einen der beiden korrekt arbeiten FFs trifft, kann dieser zusätzliche Fehler nicht mehr korrigiert werden.

Die US 2002/074609 A1 beschreibt eine Speicherzelle 100 mit drei scanfähigen bistabile Speicherzellen, die als Flip-Flops ausgebildet sind und in einer Normalbetriebsart ein digitales Eingangssignal und ein Taktsignal empfangen. Jedes bistabile Speicherelement gibt ein Ausgangssignal an ein Majoritäts-Gate ab, das an einem ersten Ausgang der Speicherzelle ein Ausgangssignal gemäß der Majorität der digitalen Eingangssignale erzeugt. Die Speicherelemente weisen jeweils zweite Ausgänge auf, die es ermöglichen, die Speicherzelle wahlweise in eine Scanbetriebsart umzuschalten, in welcher die bistabilen Speicherelemente zu einem Schieberegister verbunden sind. Das Ausgangssignal des Schieberegisters liegt an einem Ausgang der Speicherzelle an. Auf diese Weise lässt sich die korrekte Funktion der bistabilen Speicherelemente überprüfen.

Hiervon ausgehend ist es daher eine Aufgabe der vorliegenden Erfindung eine fehlertolerante Speicherschaltung zu schaffen, die einen strukturellen Schaltungstest zulässt, um neben der Funktionsfähigkeit auch die Fehlertoleranzeigenschaften zu testen.

Im Folgenden werden die Begriffe "Signal", "Datensignal", "Daten" und "Datum" in einem äquivalenten Sinn gebraucht und bezeichnen digitale Signale oder Daten, welche die Werte 0 und 1 annehmen können und insbesondere aus einer Abfolge der Werte 0 und 1 gebildet sind. Außerdem werden die Begriffe "pegelgesteuertes Flip-Flop" und "Latch" synonym verwendet.

### Beschreibung der Erfindung

Zur Lösung der Aufgabe schlägt die Erfindung nach einem ersten Aspekt eine Speicherzelle zum Speichern digitaler Daten mit mindestens drei bistabilen Speicherelementen vor, die im Normalbetrieb ein digitales Eingangssignal und ein Taktsignal empfangen. Jedes bistabile Speicherelement gibt ein Ausgangssignal an einen Voter ab, der an einem ersten Ausgang der Speicherzelle ein Ausgangssignal gemäß der Majorität der digitalen Eingangssignale erzeugt. Die Speicherzelle ist wahlweise in eine Scanbetriebsart umschaltbar, in welcher die internen bistabilen Speicherelemente zu einem Schieberegister verbunden sind. In der Speicherzelle ist jedem bistabilen Speicherelement jeweils ein 2:1-Multiplexer vorgeschaltet. Die 2:1-Multiplexer führen abhängig von einem Aktivierungssignal entweder in der Normalbetriebsart jedem bistabilen Speicherelement das digitale Eingangssignal zu oder verbinden die bistabilen Speicherelemente in der Scanbetriebsart zu einem Schieberegister. Weiterhin weist die Speicherzelle einen zweiten Ausgang auf, an dem in der Scanbetriebsart das Ausgangssignal des letzten Flip-Flops in dem Schieberegister anliegt.

Die Speicherzelle kann ein SEU Ereignis in einem der bistabilen Speicherelemente korrigieren und gibt als Ausgangssignal das korrekte Datum wieder aus. Diese fehlerkorrigierende Eigenschaft maskiert jedoch auch interne Bitfehler, weshalb die bistabilen Speicherelemente zu Testzwecken wahlweise zu einem Schieberegister verbunden sind. In dieser Betriebsart ist es möglich interne Einzelbitfehler zu detektieren. In unterschiedlichen Ausführungsformen der Speicherzelle sind die bistabilen Speicherelemente entweder als einfache flankengesteuerte D-Flip-Flops, flankengesteuerte scanfähige Flip-Flops oder pegelgesteuerte Flip-Flops (Latches) ausgebildet.

Wenn die Speicherzelle mit D-Flip-Flops oder Latches ausgebildet ist, sind die Multiplexer außerhalb der Flip-Flops oder Latches angeordnet. Im Falle von scanfähigen flankengesteuerten Flip-Flops sind die Multiplexer in den Flip-Flops integriert, sodass die Flip-Flops sowohl einen Dateneingang als auch einen Scandateneingang aufweisen. In den scanfähigen Flip-Flops leitet der integrierte Multiplexer intern nur das eine oder das andere Signal zur Speicherung weiter.

Der Ausgang des letzten bistabilen Speicherelements in dem Schieberegister ist beispielsweise mit einem Eingang eines Gatters verbunden, das mit dem Aktivierungssignal für die Scanbetriebsart verbunden ist. Der Ausgang des Gatters bildet dann den zweiten Ausgang der Speicherzelle, der notwendig ist, um die Speicherzelle mit einer weiteren scanfähigen Zelle zu verbinden, weil der erste Ausgang der Speicherzelle ein korrigiertes Datum enthält und damit jeden internen Fehler maskieren würde. Das Gatter, das dem zweiten Ausgang vorgeschaltet ist, hält den zweiten Ausgang im Normalbetrieb konstant. Das trägt zu einer geringeren Leistungsaufnahme der Speicherzelle bei, da Transitionen der dahintergeschalteten Logik vermieden werden. Gleichzeitig sorgt dieses Gatter für eine Verzögerung des Ausgabesignals, so das ein Puffer zur Einhaltung der Hold-Zeit einer dahintergeschalteten Speicherzellen entweder gänzlich unnötig wird oder ein kleinerer verwendet werden kann. Das Gatter kann zum Beispiel ein AND-Gatter oder eine Kombination aus einem NAND-Gatter und einem Inverter sein. In manchen Anwendungsfällen ist kein Gatter notwendig, sondern es genügt ein Puffer, um das genannte Ziel zu erreichen.

In einer vorteilhaften Weiterbildung der Speicherzelle ist den Dateneingängen der bistabilen Speicherelemente ein Transientenfilter vorgeschaltet, der als Eingangssignal das digitale Eingangssignal empfängt und als Ausgangssignale mehrere Ausprägungen des Eingangssignals abgibt, wovon mindestens ein Ausgangssignal gegenüber einem anderen Ausgangssignal zeitverzögert ist.

In einer zweckmäßigen Weiterbildung der Speicherzelle ist dem Dateneingang eines bistabilen Speicherelements ein erstes Verzögerungselement und dem Dateneingang eines anderen bistabilen Speicherelements ein zweites Verzögerungselement vorgeschaltet, das eine längere Signalverzögerung bewirkt als das erste Verzögerungselement. Als Verzögerungselemente kommen logische Gatter, insbesondere AND-Gatter, Puffer und Kombinationen davon in Frage, beispielsweise auch ein NAND-Gatter und ein Inverter.

Bei einer zweckmäßigen Weiterbildung dieses Ausführungsbeispiel ist dem Dateneingang des in dem Schieberegister an zweiter Stelle angeordneten bistabilen Speicherelements das erste Verzögerungselement vorgeschaltet, und dem Dateneingang des in dem Schieberegister an dritter Stelle angeordneten bistabilen Speicherelements ist das zweite Verzögerungselement vorgeschaltet.

Die Verzögerungselemente sorgen dafür, dass ein SET an dem Eingang der Speicherzelle zu unterschiedlichen Zeiten an die Eingänge der bistabilen Speicherelemente gelangt. Auf diese Weise wird erreicht, dass an den Eingängen von zwei bistabilen Speicherelementen das richtige Datum anliegt und der Voter den Einfluss des SET korrigieren kann.

Mit Vorteil ist bei einer zweckmäßigen Weiterbildung der Speicherzelle der Ausgang des dem zweiten bistabilen Speicherelement zugeordneten Multiplexers mit dem Eingang des ersten Verzögerungselements und der Ausgang des dem dritten bistabilen Speicherelement zugeordneten Multiplexers mit dem Eingang des zweiten Verzögerungselements verbunden.

Für die richtige Funktion der Scanbetriebsart ist es notwendig, dass die Hold-Zeit der Flip-Flops kleiner ist als die Verzögerungsdauer des ersten Verzögerungselements. Mit der richtigen Wahl des Verzögerungselements lässt sich diese Voraussetzung erfüllen. Da das zweite Verzögerungselement eine längere Verzögerungsdauer aufweist, wird die Voraussetzung auch für das dritte bistabile Speicherelement erfüllt. Der vorgeschlagene Aufbau der Speicherzelle hat den Vorteil, dass die Verzögerungselemente einerseits im Normalbetrieb dafür sorgen, dass ein am Eingang der Speicherzelle anliegender SET durch die Verzögerung der Verzögerungselemente nur von höchstens einem der internen FFs gespeichert und folglich durch den Voter korrigiert werden kann. Zum anderen dienen die Verzögerungselemente in der Scanbetriebsart dem Einhalten der Hold-Zeiten der internen als Schieberegister verbundenen FFs und damit der Gewährleistung der korrekten Funktion der Speicherzelle in dieser Betriebsart. Die Verzögerungselemente können zum Beispiel als Pufferspeicher, als Kombination eines AND-Gatters mit einem Puffer oder als Kombination von einem NAND-Gatter mit einem Inverter eingesetzt werden. Für kurze Verzögerungszeiten kann auch nur ein AND-Gatter ausreichen.

Bei einem zweckmäßigen Ausführungsbeispiel ist zwischen dem Ausgang des ersten bistabilen Speicherelements des Schieberegisters, der mit einem Eingang des dem zweiten bistabilen Speicherelement zugeordneten Multiplexers verbunden ist, ein weiterer Puffer zwischengeschaltet, und zwischen dem Ausgang des zweiten Flip-Flops des Schieberegisters, der mit einem Eingang des dem dritten Flip-Flop zugeordneten Multiplexers verbunden ist, ist ein weiteres Verzögerungselement zwischengeschaltet.

In den Fällen, wo die Hold-Zeit der bistabilen Speicherelemente größer ist als die Verzögerungsdauer der Verzögerungselemente, die zur Verzögerung des Eingabesignals der TMR-Speicherzelle und damit zur Korrektur eines SETs dienen, hat es sich als zweckmäßig erwiesen das Ausgangssignal des ersten und des zweiten bistabilen Speicherelements mit einem weiteren Verzögerungselement zu verzögern. Auf diese Weise wird erreicht, dass die Hold-Zeit der bistabilen Speicherelemente kleiner ist als die Gesamtverzögerungszeit aller zwischengeschalteten Verzögerungselemente und Multiplexer.

Bei einem vorteilhaften Ausführungsbeispiel weist die Speicherzelle drei flankengesteuerte scanfähige Flip-Flops auf, die jeweils einen Scandateneingang umfassen. In diesem Fall ist den Scandateneingängen der in dem Schieberegister an zweiter Stelle und an dritter Stelle angeordneten Flip-Flops ein Verzögerungselement vorgeschaltet.

Scanfähige Flip-Flops verfügen über eine interne Umschaltung zwischen der Normal- und der Scanbetriebsart und weisen daher getrennte Daten- und Scandateneingänge auf. Entsprechend können die Verzögerungselemente, die an den Dateneingängen dafür sorgen, dass ein SET nicht an allen Eingängen der Flip-Flops gleichzeitig auftritt, nicht dafür genutzt werden, um sicherzustellen, dass die Hold-Zeit der bistabilen Speicherelemente in der Scanbetriebsart eingehalten wird.

Gemäß einer zweckmäßigen Weiterbildung der Speicherzelle mit drei flankengesteuerten scanfähigen Flip-Flops ist dem zweiten und dem dritten Flip-Flop jeweils ein AND-Gatter zugeordnet, dessen einer Eingang mit dem Ausgang des in dem Schieberegister vorhergehenden Flip-Flops und dessen anderer Eingang mit dem Aktivierungssignal verbunden ist. Der Ausgang des AND-Gatters ist entweder direkt mit dem Scandateneingang des in dem Schieberegister dahinter angeordneten oder geschalteten Flip-Flops verbunden, oder dem zweiten und dem dritten Flip-Flop wird jeweils ein weiteres Verzögerungselement zugeordnet, dessen Eingang mit dem Ausgang des jeweiligen AND-Gatters und dessen Ausgang mit dem Scaneingang des zugeordneten (zweiten bzw. dritten) Flip-Flops verbunden ist.

Die AND-Gatter dienen bei dieser Anordnung der Unterdrückung von Schaltungsaktivität der Puffer und interner Knoten der scanfähigen Flip-Flops in der Normalbetriebsart der Speicherzelle und können somit zu einer geringeren Leistungsaufnahme der Speicherzelle beitragen. Die dem AND-Gatter nachgeschalteten Puffer werden in dieser Anordnung nur benötigt, wenn die Hold-Zeit der Flip-Flops größer ist, als die Verzögerungszeit der AND-Gatter und werden so gewählt, dass die Gesamtverzögerung von AND-Gatter und dem Puffer größer als die Hold-Zeit der Flip-Flops ist.

Mit Vorteil ist zwischen dem Ausgang des dritten Flip-Flops in dem Schieberegister und dem zweiten Ausgang der Speicherzelle ein logisches Gatter angeordnet, insbesondere ein AND-Gatter.

Dieses zwischengeschaltete Gatter vermeidet Transitionen der dahintergeschalteten Logik und trägt damit zu einer geringen Leistungsaufnahme eines Gesamtsystems bei. Gleichzeitig sorgt dieses Gatter für eine Verzögerung des Ausgabesignals, so das ein Verzögerungselement zur Einhaltung der Hold-Zeit zwischen hintereinandergeschalteten Speicherzellen entweder nicht notwendig ist oder kleiner dimensioniert werden kann.

Gemäß einer vorteilhaften Ausführungsform sind die bistabilen Speicherelemente als pegelgesteuerte Latches ausgebildet. In der Scanbetriebsart ist das zweite Latch in dem Schieberegister mit einem anderen Taktsignal getaktet als das erste und das dritte Latch in dem Schieberegister. Der Ausgang des dritten Latches ist mit einem Dateneingang eines vierten pegelgesteuerten Latches verbunden, dessen Ausgang den zweiten Ausgang der Speicherzelle bildet.

Wenn die Speicherzelle aus pegelgesteuerten Latches aufgebaut ist, dann wird ein viertes Latch notwendig, um in der Scanbetriebsart ein unkorrigiertes Ausgangssignal des Schieberegisters an dem zweiten Ausgang der Speicherzelle zur Verfügung stellen zu können. Der zweite Ausgang der Speicherzelle kann mit einem Eingang einer nächsten Speicherzelle verbunden sein, um mehrere hintereinander geschaltete Speicherzellen auf Fehler testen zu können.

Gemäß einer vorteilhaften Weiterbildung ist der Ausgang des dritten Latches in dem Schieberegister mit einem ersten Eingang eines AND-Gatters verbunden, an dessen anderem Eingang das Aktivierungssignal anliegt. Der Ausgang des AND-Gatters ist mit dem Dateneingang des vierten Latches verbunden.

Das zwischen dem dritten Latch in dem Schieberegister und dem vierten Latch angeordneten AND-Gatter sorgt dafür, dass das Ausgangssignal des dritten Latches nur in der Scanbetriebsart an das vierte Latch abgegeben wird und vermeidet auf diese Weise in der Normalbetriebsart ein unnötiges Schalten des vierten Latches, was den Energieverbrauch der Speicherzelle reduziert.

In einer besonders zweckmäßigen Weiterbildung der Speicherzelle mit Latches ist vor dem Taktsignaleingang des zweiten Latches in dem Schieberegister ein 2:1-Multiplexer angeordnet, der abhängig von dem Aktivierungssignal dem zweiten Latch unterschiedliche Taktsignale zuführt.

Bei pegelgesteuerten Latches ist es in der Scanbetriebsart notwendig, dass zwei in einem Schieberegister nacheinander angeordnete Latches jeweils mit einem anderen Taktsignal angesteuert werden, damit ein unerwünschtes Propagieren eines Scandatenwertes durch mehrere Latches innerhalb eines Scantaktzyklus verhindert wird. Zweckmäßigerweise wird im vorliegenden Fall das zweite und das vierte Latch mit dem anderen Taktsignal angesteuert.

Weitere die Vorteile der erfindungsgemäßen Speicherzelle sind:
Fehlertoleranz auf Basis von Triple-Modular-Redundancy (TMR) gegenüber Single-Event-Transients (SET) der vorgeschalteten Logik für den Datenpfad sowie Single-Event-Upsets (SEU) in einem der internen sequentiellen Basiszellen, die als Flip-Flops ausgebildet sind.
Unterstützung von vollständigen strukturellen Tests durch Verbindung der internen sequentiellen Basiszellen zu einem Schieberegister (einer sogenannten Scanchain)
Aufgrund der speziellen Architektur, wie z.B. dem Einsatz von AND-Gattern zur Verringerung von interner Schaltungsaktivität, kann die neuartige sequentielle Zelle eine geringere Leistungsaufnahme als vergleichbare Lösungen haben.

Gemäß einem zweiten Aspekt der Erfindung wird ein Verfahren zur Erzeugung eines Testmusters vorgeschlagen, um eine Schaltung mit einer Speicherzelle gemäß dem ersten Aspekt der Erfindung auf Bitfehler zu prüfen. Das Verfahren umfasst folgende Schritte:
- Laden von Daten für Standardzellen aus einer Bibliothek in ein Schaltungsentwurfswerkzeug;
- Erstellen einer Schaltung auf Basis der zuvor geladenen Daten;
- Erstellen einer Netzliste der Schaltung;
- Erstellen einer Netzliste der Speicherzelle;
- Laden von Daten für Standardzellen aus der Bibliothek in ein Testmustergenerierungswerkzeug;
- Laden der Struktur der Schaltung in das Testmustergenerierungswerkzeug;
- Laden der Netzliste der Schaltung in das Testmustergenerierungswerkzeug;
- Laden der Netzliste der Speicherzelle in das Testmustergenerierungswerkzeug; und
- Erzeugen des Testmusters für die Schaltung.

Das erfindungsgemäße Verfahren greift sowohl auf die Netzliste der Schaltung als auch auf die Netzliste der Speicherzelle zu. Nur mit Kenntnis der internen Struktur der komplexen Speicherzelle ist es möglich, ein Testmuster zu generieren, mit welchem eine Schaltung, die komplexe Speicherzellen benutzt, auf interne Bitfehler getestet werden kann.

Im Folgenden werden die hier beschriebenen Speicherzellen kurz als SDTMR-FF (kurz für Scannable-Delta-Triple-Modular-Redundant-Flip-Flop) bzw. SDTMR-L (für Scannable-Delta-Triple-Modular-Redundant-Latch) Zelle oder zusammenfassend als SDTMR-Zelle bezeichnen. Alle hier vorgestellten Zellen lassen sich aus Gattern aus konventionellen Standardzellbibliotheken zusammenstellen. Eine Speicherzelle wird auch kurz als Zelle oder komplexe Zelle bezeichnet.

### Kurze Beschreibung der Zeichnung

Nachfolgend wird die Erfindung anhand einer Ausführungsform unter Bezugnahme auf die begleitenden Figuren exemplarisch näher erläutert. Alle Figuren sind rein schematisch. Es zeigen:
- Fig. 1A: eine SDTMR-FF-Speicherzelle mit einem Transientenfilter, die aus konventionellen D-Flip-Flops aufgebaut ist;
- Fig. 1B: die SDTMR-FF-Speicherzelle aus Figur 1A mit Verzögerungselementen als Transientenfilter für den Datenpfad;
- Fig. 2: ein Zeitdiagramm der SDTMR-FF Speicherzelle aus Figur 1B;
- Fig. 3A, 3B: weitere Zeitdiagramme der SDTMR-FF Speicherzelle aus Figur 1B im Scanbetrieb;
- Fig. 4: eine SDTMR-FF-Speicherzelle, die aus scanbaren Flip-Flops aufgebaut ist;
- Fig. 5: eine SDTMR-L-Speicherzelle, die aus pegelgesteuerten Latches aufgebaut ist
- Fig. 6: ein Zeitdiagramm der SDTMR-L-Speicherzelle aus Figur 5;
- Fig. 7: ein Zeitdiagramm SDTMR-L-Speicherzelle aus Figur 5 im Scanbetrieb; und
- Fig. 8: ein schematisches Flussdiagramm für ein Verfahren zur Herstellung von Testmustern für SDTMR-Speicherzellen.

Gleiche oder ähnliche Elemente sind in den Figuren mit gleichen oder ähnlichen Bezugszeichen versehen. Der Einfachheit halber werden Ein- bzw. Ausgänge und die dort anliegenden Signale in der Regel mit denselben Bezugszeichen bezeichnet, wenn dadurch keine Unklarheiten entstehen.

### Ausführungsbeispiele

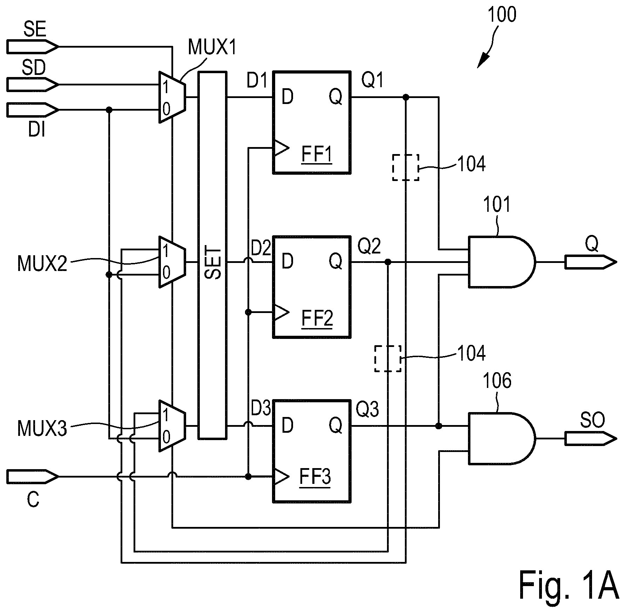

In Figur 1A ist ein Schaltbild einer Speicherzelle dargestellt, die als Ganzes mit dem Bezugszeichen 100 bezeichnet ist. Die Speicherzelle ist aus drei konventionellen D-Flip-Flops FF1-FF3 aufgebaut. Bei der Speicherzelle handelt es sich somit um eine Scannable-Delta-Triple-Modular-Redundant-Flip-Flop (SDTMR-FF) Zelle. Die SDTMR-FF-Zelle empfängt an einem Dateneingang DI ein Eingangssignal. Der Dateneingang DI ist mit den jeweiligen Dateneingängen D1-D3 der Flip-Flops FF1-FF3 verbunden. An einen Takteingang C liegt ein Taktsignal C an, das an die jeweiligen Taktsignaleingänge der Flip-Flops FF1-FF3 abgegeben wird. Die Ausgänge Q1-Q3 der Flip-Flops FF1-FF3 sind mit einem Voter (Majoritäts-Gate) 101 verbunden sind. Der Voter 101 führt eine Mehrheitsentscheidung durch. Das bedeutet, dass wenn an mindestens zwei der drei Eingänge des Voters 101 ein Signal 0 bzw. 1 anliegt, dann ist das Ausgangssignal des Voters 101 ebenfalls 0 bzw. 1. Wenn ein SEU auftritt und das Signal in einem der Flip-Flops FF1-FF3 verfälscht, d.h. ein gespeichertes Datum 0 in ein Datum 1 verfälscht oder umgekehrt, dann bleibt das Ausgangssignal des Voters 101 unverändert. Der von dem SEU verursachte Fehler wird somit korrigiert und führt zu der Eigenschaft der SDTMR-FF-Zelle interne dem Voter 101 vorgelagerte Einzelbitfehler in Gestalt von einem SEU zu korrigieren.

Um darüber hinaus auch am Eingang der Speicherzelle anliegende durch SETs verursachte transiente Fehler zu korrigieren, sind weitere Maßnahmen notwendig. Wie eingangs bereits erwähnt ist ein SET ein kurzzeitiger Signalpuls in Gestalt einer Wertefolge 0-1-0 oder 1-0-1, der zum Beispiel durch ein Strahlungspartikel verursacht werden kann. Die Dauer eines SET ist abhängig von dessen Ursache sowie der verwendeten Schaltungstechnologie. Z.B. hängt die Dauer bei strahlungsbedingten SET von der Art und Energie des Partikels ab und kann zwischen 10ps und mehreren Nanosekunden liegen. Um sicherzustellen, dass ein einzelner SET nicht gleichzeitig an allen Dateneingängen D1-D3 der Flip-Flops FF1-FF3 ein fehlerhaftes Signal erzeugen kann, ist den Dateneingängen der Flip-Flops FF1-FF3 ein Transientenfilter SET (SET-Filter) vorgeschaltet, welches das digitale Eingangssignal empfängt und jeweils eine Ausprägung des Eingangssignals als Ausgangssignale D1,D2,D3 an das Flip-Flop FF1, FF2 bzw. FF3 abgibt. Das Ausgangssignal D2 ist dabei gegenüber dem Ausgangssignal D1 zeitverzögert und das Ausgangssignal D3 ist gegenüber dem Ausgangssignal D2 zeitverzögert. Geeignete SET-Filter sind zum Beispiel in der europäischen Patentanmeldung EP 20194694.4 offenbart.

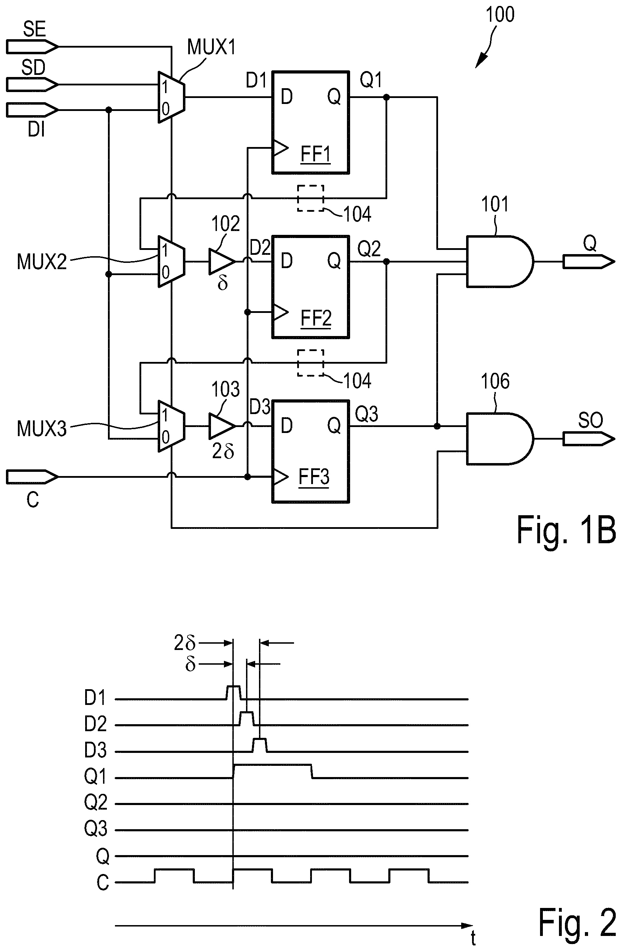

In Figur 1B ist ein Ausführungsbeispiel der Speicherzelle aus Figur 1A in größerer Einzelheit dargestellt. Bei diesem Ausführungsbeispiel sind den Flip-Flops FF2, FF3 Verzögerungselemente (Puffer) 102,103 vorgeschaltet. Der Puffer 102 vor dem Eingang des Flip-Flops FF 2 verzögert das Eingangssignal um eine Zeitdauer δ, was ungefähr der Länge eines SETs entspricht. Der Puffer 103 vor dem Eingang D3 des Flip-Flops FF3 verzögert das Eingangssignal um die Zeitdauer 2δ. Durch die von den Puffern 102,103 bewirkten Verzögerungen der Eingangssignale für die Flip-Flops FF2 und FF3 wird gewährleistet, dass bei einem Transienten am Eingang DI mindestens zwei Flip-Flops den korrekten Wert erhalten, wie mit Bezug auf Figur 2 erläutert wird.

Figur 2 zeigt ein Zeitdiagramm der SDTMR-FF-Zelle, wenn an dem Eingang DI ein SET auftritt und einen 0-1-0 Impuls an den Eingängen D der Flip-Flops FF1 bis FF3 bewirkt. Die steigende Flanke des SET tritt um eine bestimmte Zeitdauer vor der steigenden Flanke des Taktsignals C auf und steht für mindestens eine Zeitdauer nach der steigenden Flanke des Taktsignals C an. Hierbei ist zu beachten, dass ein Signal für eine als Set-up-Zeit vor und eine Hold-Zeit nach der steigenden Taktflanke des Taktsignals C mit stabilem Pegel anliegen muss, damit das Signal abgespeichert wird. Bei dem Impuls an dem Eingang D des Flip-Flops FF1 ist das der Fall, so dass an einem Ausgang Q des Flip-Flops FF1 als Ausgangssignal Q1 ein Wert 1 abgegeben wird. Die steigende Flanke des Impulses des SET erreicht wegen des Puffers 102 den Eingang D des Flip-Flops FF2 erst mit einer Verzögerung δ und nach der steigenden Flanke des Taktsignals C. Der SET wird somit von dem Flip-Flop FF2 nicht gespeichert und ein Ausgangssignal Q2 des Flip-Flops FF2 bleibt auf einem Wert 0. Die steigende Flanke des Impulses des SET erreicht wegen des Puffers 103 den Eingang D des Flip-Flops FF3 erst mit einer Verzögerung 2δ und ebenfalls nach der steigenden Flanke des Taktsignals C. Der SET wird somit von dem Flip-Flop FF3 nicht gespeichert und ein Ausgangssignal Q3 des Flip-Flops FF3 bleibt auf einem Wert 0. Die Ausgangssignale Q1 bis Q3 werden an den Voter 101 abgegeben, der eine Mehrheitsentscheidung trifft und als Ausgangssignal Q den Wert 0 abgibt und somit den Einfluss des SET korrigiert.

Die fehlerkorrigierende Eigenschaft der SDTMR-FF-Zelle hat jedoch den Nachteil, dass auch schaltungsinterne Einzelbitfehler maskiert werden und daher nicht ohne weiteres festgestellt werden können. Um solche internen Fehler detektieren zu können, werden die drei Flip-Flops FF1 bis FF3 zu einem Schieberegister (Scankette) verbunden. Ein Scanvorgang, welcher der Detektion von internen Fehlern dient, wird mit einem Aktivierungssignal SE (Scan Enable) eingeleitet. Das Aktivierungssignal SE wird an Selektoreingänge von 2-zu-1-Multiplexern (2:1-Multiplexer) MUX1 bis MUX3 angelegt. Der Ausgang des Multiplexers MUX1 ist mit dem Eingang D des Flip-Flops FF1, der Ausgang des Multiplexers MUX2 ist mit dem Eingang des Puffers 102 und der Ausgang des Multiplexers MUX3 ist mit dem Eingang des Puffers 103 verbunden. Jeweils ein Eingang der Multiplexer MUX1 bis MUX3 ist mit dem Dateneingang DI verbunden. Der andere Eingang des Multiplexers MUX1 ist mit einem Scaneingang SD verbunden, sodass der Multiplexer MUX1 abhängig von dem Aktivierungssignal wahlweise den Scaneingang SD oder den Dateneingang DI an den Eingang D des Flip-Flops FF1 durchschaltet. Um die einzelnen Flip-Flops FF1 bis FF3 zu einer Scankette zusammenzufassen wird der Ausgang Q des Flip-Flops FF1 mit dem anderen Eingang des Multiplexer MUX2 und der Ausgang Q des Flip-Flops FF2 mit dem anderen Eingang des Multiplexers MUX3 verbunden. Mit dieser Schaltung wird erreicht, dass in Scanbetrieb ein anfänglich an dem Scaneingang SD anliegender Wert mit jedem Zyklus des Taktsignals von einem Flip-Flop zu den nächsten weitergeschoben wird. Wenn an dem Ende der Scankette ein anderer Wert aus der Scankette herauskommt als der, der anfänglich eingespeichert wurde, dann deutet das auf einen internen Einzelbitfehler hin.

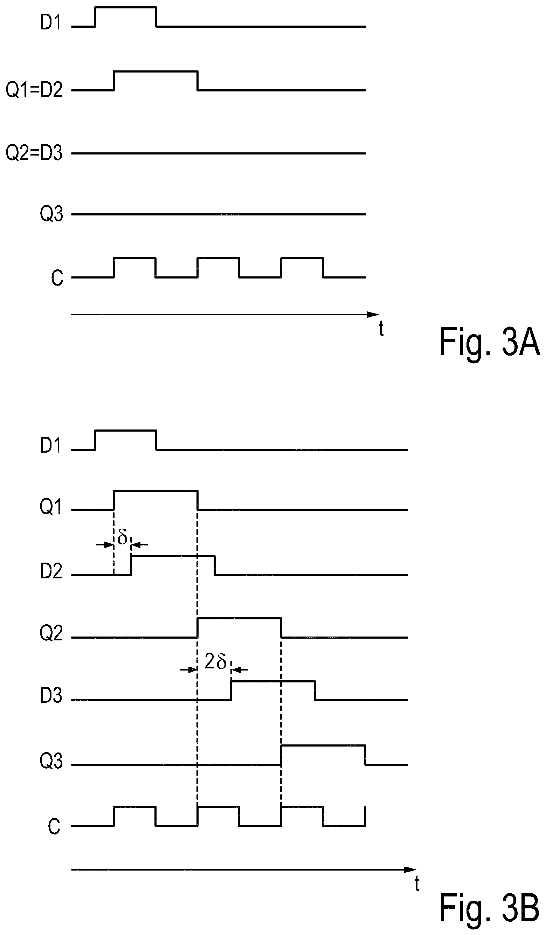

Für das richtige funktionieren der Scankette ist allerdings zu beachten, dass Eingangssignale für die Flip-Flops für eine bestimmte Zeit vor (Set-up-Zeit) und nach (Hold-Zeit) der steigenden Taktflanke stabil am Eingang eines Flip-Flops anliegen müssen. Die Set-up-Zeit ist für den internen Aufbau nicht weiter erheblich, aber um die Hold-Zeiten der Flip-Flops einzuhalten, müssen zwischen dem Flip-Flop FF1 und dem Flip-Flop FF2 bzw. den Flip-Flop FF2 und dem Flip-Flop FF3 Puffer vorgesehen werden. Diese Notwendigkeit wird in den Figuren 3A und 3B dargestellten Zeitdiagrammen veranschaulicht.

Figur 3A zeigt ein Zeitdiagramm für eine SDTMR-FF-Zelle ohne das Vorhandensein der Puffer 102 und 103. Das an dem Eingang D1 anliegende Signal wird mit der ersten steigenden Flanke des Taktsignals C in das Flip-Flop FF1 eingelesen und das Ausgangssignal Q1 erzeugt. Mit der nächsten steigenden Flanke des Taktsignals C geht das Ausgangssignal Q1 wieder auf den Wert 0 zurück. Ohne den Puffer 102 entspricht das Ausgangssignal Q1 dem Eingangssignal D2 an dem zweiten Flip-Flop FF2. Noch während der Hold-Zeit des Flip-Flops FF2 nimmt das Eingangssignal D2 den Wert 0 an, sodass der zuvor anliegende Wert 1 des Ausgangssignals nicht in das Flip-Flop FF 2 eingelesen wird und das Ausgangssignal Q2 konstant auf dem Wert 0 bleibt. Das Ausgangssignal Q2 bildet das Eingangssignal für das Flip-Flop FF3, das demzufolge ebenfalls als Ausgangswert den Wert 0 abgibt. Das bedeutet, dass das Eingangssignal D1 auf dem Weg durch die Scankette verloren gegangen ist, weil das Ausgangssignal des Flip-Flops FF1 während der Hold-Zeit des Flip-Flops FF2 nicht stabil zur Verfügung stand. Dieses Problem lässt sich mit den oben erwähnten Puffern zwischen den ersten und zweiten bzw. dem zweiten und dritten Flip-Flop beheben. Zu diesem Zweck werden wieder die Puffer 102 und 103 verwendet, welche die Korrektur eines SET ermöglichen, wie es im Zusammenhang mit den Figuren 1B und 2 beschrieben wurde.

Figur 3B zeigt ein Zeitdiagramm für der SDTMR-FF-Zelle mit Puffern 102 und 103 wie sie in Figur 1B dargestellt ist. Das Eingangssignal D1 wird bei der ersten steigenden Flanke des Taktsignals C eingelesen und das erste Flip-Flop FF1 erzeugt das Ausgangssignal Q1. Das Ausgangssignal Q1 wird von dem Puffer 102 verzögert, sodass an dem Eingang D2 ein um die Zeitdauer δ verzögertes Signal D2 ansteht. Das Signal D2 hat nach der nächsten ansteigenden Flanke des Taktsignals C während der Hold-Zeit des Flip-Flops FF2 noch den Wert 1 und wird in das Flip-Flop FF2 eingelesen. Das Flip-Flop FF2 gibt ein dementsprechendes Ausgangssignal Q2 mit dem Wert 1 ab. Das Ausgangssignal Q2 wird von dem Puffer 103 verzögert, so dass das Eingangssignal D3 für das Flip-Flop FF3 um die Zeitdauer 2δ verzögert ist und während der nächsten ansteigenden Flanke des Taktsignals C eingelesen wird. Das Flip-Flop FF 3 erzeugt daraufhin ein Ausgangssignal Q3 mit dem Wert 1. In dem in Figur 3 dargestellten Zeitdiagramm wird deutlich, dass ein Eingangssignal während dreier Taktzyklen durch die Scankette hindurchgeschoben wird.

Hierbei ist zu beachten, dass die Hold-Zeit der Flip-Flops FF1 bis FF3 kleiner ist als die Verzögerungsdauer δ. Ist das nicht der Fall, so muss zwischen den Datenausgang Q des Flip-Flops FF1 und dem Multiplexer MUX2 bzw. zwischen dem Datenausgang Q des Flip-Flops FF2 und dem Multiplexer MUX3 jeweils ein weiterer Puffer 104 als Verzögerungselement eingefügt werden. Die Puffer 104 sind in den Figuren 1A und 1B gestrichelt dargestellt.

Wieder mit Bezug auf Figur 1B ist zu erkennen, dass die SDTMR-FF-Zelle 100 über einen zusätzlichen Ausgang SO verfügt, über den die Zelle 100 mit einer weiteren scanfähigen Zelle verbindbar ist. Dieser weitere Ausgang ist notwendig, da der Ausgang Q der SDTMR-FF-Zelle das bereits korrigierte Datum enthält und damit jeden internen Fehler maskieren würde. Dem Ausgang SO wird ein AND-Gatter 106 vorgeschaltet, um den Ausgang SO im Normalbetrieb, d.h. wenn die SDTMR-FF-Zelle nicht im Scanbetrieb ist, konstant zu halten. Dies trägt zu der geringeren Leistungsaufnahme Fälle bei, da Transitionen der dahintergeschalteten Logik, zum Beispiel Puffer, vermieden werden. Gleichzeitig sorgt das AND-Gatter 106 für eine Verzögerung des Ausgabesignals, so das kein Puffer zur Einhaltung der Hold-Zeit zwischen zwei hintereinandergeschalteten SDTMR-FF Zellen nötig ist. In anderen Ausführungsbeispielen werden anstelle des AND-Gatters 106 andere logische Gatter verwendet.

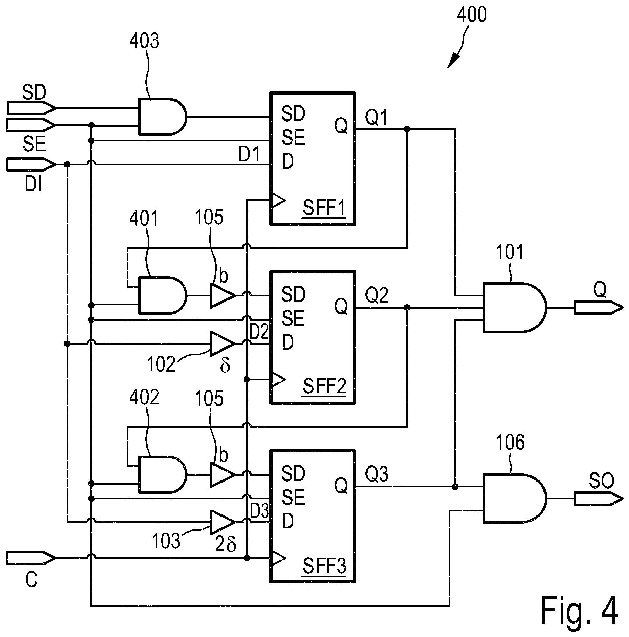

In Figur 4 ist eine erfindungsgemäße SDTMR-FF-Speicherzelle 400 mit drei scanfähigen Flip-Flops SFF1-SFF3 dargestellt. Bei den scanfähigen Flip-Flops SFF1-SFF3 sind die in den Figuren 1A und 1B gezeigten die Multiplexer MUX1-MUX3 bereits integriert, wodurch interne Knoten optimiert angeordnet werden können. Aufgrund des integrierten Multiplexers verfügen die scanfähigen Flip-Flops SFF1 bis SFF3 über einen Scan-Enable-Eingang SE, einen Scan-Dateneingang SD und einen normalen Dateneingang D sowie einen Takteingang. Aus denselben Gründen wie bei der in Figur 1B dargestellten SDTMR-FF-Zelle 100 mit konventionellen Flip-Flops ist vor dem Dateneingang D des zweiten scanfähigen Flip-Flops SFF2 ein Puffer 102 angeordnet, der eine Signalverzögerung um die Zeitdauer δ bewirkt. Weiterhin ist vor dem Dateneingang D des dritten scanfähigen Flip-Flops SFF3 ein Puffer 103 angeordnet, der eine Signalverzögerung um die Zeitdauer 2δ bewirkt. Die Puffer 102, 103 können bei dem vorliegenden Ausführungsbeispiel jedoch nicht dazu verwendet werden, um im Scanbetrieb die Hold-Zeiten der Flip-Flops SFF1,SFF2 einzuhalten, weil die Scandaten über eine andere Verbindung geführt werden. Vor dem Scandateneingang SD des zweiten und des dritten Flip-Flops SFF2, SFF3 sind daher Puffer 105 angeordnet. Vor die Puffer 105 ist darüber hinaus jeweils ein AND-Gatter 401,402 vorgeschaltet. Die Puffer 105 sind so dimensioniert, dass die Summe der Propagationsverzögerungen des AND-Gatters 401 bzw. 402 und des Puffers 105 größer ist als die Hold-Zeit des Flip-Flops SFF2 bzw. SFF3. In anderen Ausführungsbeispielen können die Puffer 102,103,105 durch andere Verzögerungselemente ersetzt sein.

Außerdem ist ein AND-Gatter 403 vor den Scan-Dateneingang SD des ersten Flip-Flops SFF1 geschaltet. Die AND-Gatter 401-403 verhindern unnötiges Schalten der Puffer 104 bzw. interner Knoten in den Flip-Flops SFF1-SFF3. Das Aktivierungssignal (Scan-Enable-Signal) SE ist eines der Eingangssignale für alle AND-Gatter 401-403. Das andere Eingangssignal für das AND-Gatter 401 ist das Ausgangssignal Q1 des ersten Flip-Flops SFF1. Das andere Eingangssignal für das AND-Gatter 402 ist das Ausgangssignal Q2 des zweiten Flip-Flops SFF2. Schließlich ist andere Eingang des AND-Gatters 403 dem Scandateneingang SD verbunden.

Die Fehlerkorrektur im Normalbetrieb funktioniert bei SDTMR-FF-Zelle 400 wie bei der der SDTMR-FF-Zelle 100 aus Figur 1B. Dasselbe gilt für den Scanbetrieb.

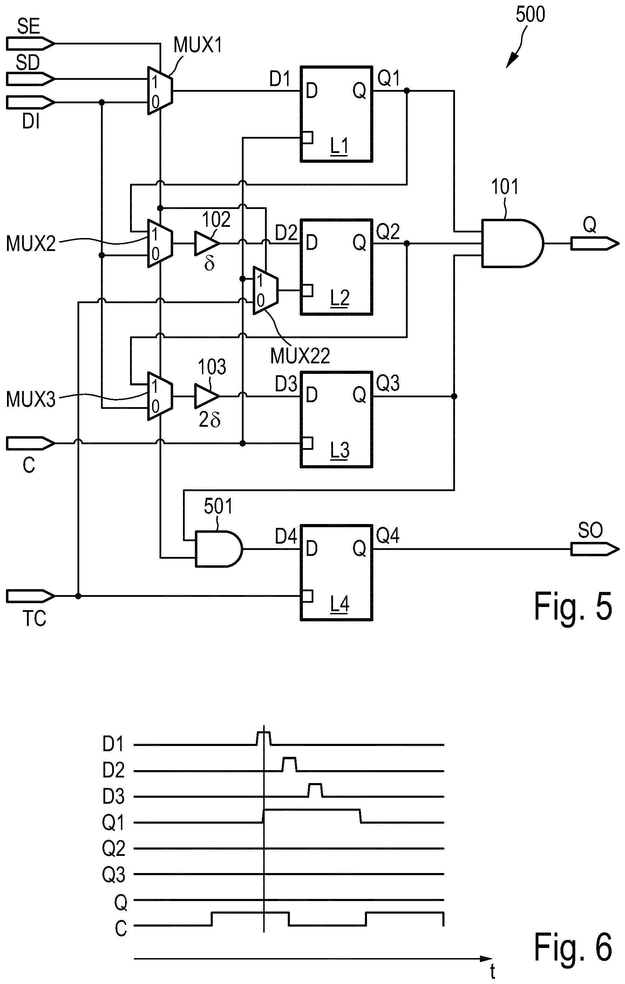

Figur 5 zeigt ein Ausführungsbeispiel einer SDTMR-Speicherzelle, die mit pegelgesteuerten Latches verwirklicht ist und dementsprechend als "Scannable-Delta-Triple-Modular-Redundant-Latch" (SDTMR-L) bezeichnet wird. Die SDTMR-L-Zelle wird als Ganzes mit dem Bezugszeichen 500 bezeichnet. Im Unterschied zu der SDTMR-L-Zelle 500 wurden bei den in den Figuren 1A,1B und 4 dargestellten Ausführungsbeispielen der Speicherzellen 100,400 flankengesteuerte Flip-Flops eingesetzt. Die SDTMR-L-Zelle 500 weist vier pegelgesteuerte Latches L1-L4 auf, von denen die Latches L1-L3 als Scankette angeordnet sind. Das vierte Latch L4 wird nur für den Scanbetrieb eingesetzt. Abgesehen davon, dass die Latches L1-L3 pegelgesteuert sind, funktioniert die SDTMR-L-Zelle 500 ganz entsprechend wie die in Figur 1B beschriebene SDTMR-FF-Zelle 100. Im Normalbetrieb werden die Multiplexer MUX1-MUX3 so geschaltet, dass der Dateneingang DI mit den Dateneingängen D der Latches L1-L3 verbunden ist.

Figur 6 zeigt ein Zeitdiagramm für die SDTMR-L Zelle 500, wenn an dem Dateneingang DI ein SET auftritt. Der SET tritt zeitlich betrachtet zuerst als Eingangssignal D1 an dem Latch L1 auf, wegen des Puffers 102 mit einer zeitlichen Verzögerung δ als Eingangssignal D2 an dem Latch L2, und wegen des Puffers 103 mit einer zeitlichen Verzögerung 2δ als Eingangssignal D3 an dem Latch L3 auf. Das Latch L1 ist zu dem Zeitpunkt, an dem als Eingangssignal D1 ansteht von dem Taktsignal C aktiviert und erzeugt das Ausgangssignal Q1 mit dem Wert 1. Zu dem Zeitpunkt, an dem als Eingangssignal D2 auftritt, ist das Latch L2 nicht mehr aktiviert und das Ausgangssignal Q2 bleibt auf dem Wert 0. Gleiches gilt für das Latch L3. Zu dem Zeitpunkt, an dem als Eingangssignal D3 auftritt, ist das Latch L3 nicht mehr aktiviert und das Ausgangssignal Q3 bleibt auf dem Wert 0. Der Voter 101 empfängt somit zweimal den Wert 0 und einmal den Wert 1 und erzeugt folglich als Ausgangssignal Q den Wert 0. Im Ergebnis werden von der SDTMR-L-Zelle 500 ein an dem Dateneingang auftretender SET korrigiert.

Ähnlich wie bei den bekannten Level-Sensitive-Scan-Design (LSSD) Testverfahren wird ein weiteres Taktsignal TC für den Scanbetrieb eingeführt, weil innerhalb der Scankette zwei hintereinandergeschaltete Latches mit unterschiedlichen Taktsignalen betrieben werden müssen, um ein bitweises Einschieben der Daten in die Scankette zu ermöglichen. Im vorliegenden Ausführungsbeispiel wird im Scanbetrieb das Taktsignal TC an das Latch L2 angelegt. Zu diesem Zweck ist vor dem Taktsignaleingang des Latches L2 ein Multiplexer MUX22 angeordnet, der dem Taktsignaleingang im Normalbetrieb das Taktsignal C zuführt und im Scanbetrieb das zweite Taktsignal TC. Die Umschaltung des Multiplexers MUX22 erfolgt mittels des Aktivierungssignals SE. Ohne diese Maßnahme würden die angelegten Scandaten durch eine vollständig transparente Scankette "durchrutschen", ohne darüber Aufschluss zu geben, ob in der Scankette ein interner Bitfehler vorliegt. Das vierte Latch L4 wird nur für den Scanbetrieb eingesetzt, um für Kompatibilität zu dem LSSD Testverfahren zu sorgen, sodass mehrere SDTMR-L-Zellen 500 ohne weitere Maßnahmen hintereinander in einer Scankette angeordnet werden. Vor den Dateneingang des Latches L4 ist ein AND-Gatter 501 vorgeschaltet. Ein Eingang des AND-Gatters 501 ist mit dem Ausgangssignal Q3 verbunden und der andere Eingang mit dem Aktivierungssignal SE. Das Latch L4 ist mit dem zweiten Taktsignal TC getaktet und gibt im Scanbetrieb das Ausgangssignal Q4 an den Scanausgang SO ab. Da die Latches L1-L4 pegelgesteuert sind, sind zusätzliche Puffer wie bei der SDTMR-FF Zellen 100 und 400 mit den flankengesteuerten Flip-Flops FF1-FF3 bzw. SFF1-SFF3 zwischen den Latches L1 und L2 bzw. zwischen den Latch L2 und L3 nicht notwendig.

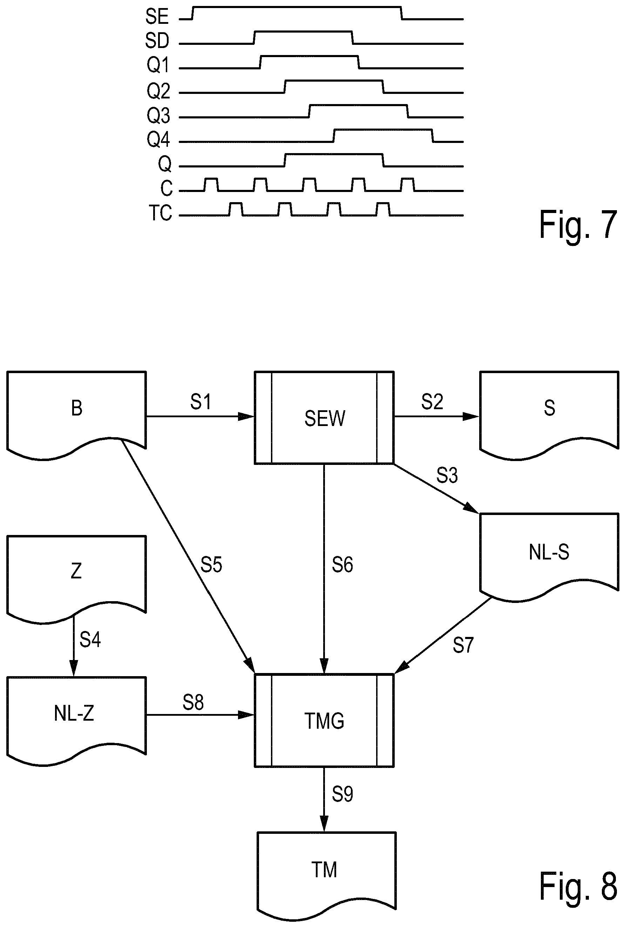

Figur 7 zeigt ein Zeitdiagramm der SDTMR-L Zelle 500 im Scanbetrieb. Aus dem Zeitdiagramm ist ersichtlich, dass das Signal an dem Scandateneingang SD Schritt für Schritt durch die SDTMR-L Zelle hindurchgeschoben wird.

Figur 8 zeigt ein schematisches Flussdiagramm für ein Verfahren zur Erzeugung von Testmustern, um die SDTMR-Zellen auf interne Bitfehler zu prüfen. Hierbei ist zu berücksichtigen, dass beim Entwurf einer Schaltung die beschriebenen SDTMR-FF- bzw. SDTMR-L-Zellen 100,400,500 als einzelnes konventionelles Flip-Flop bzw. Latch betrachtet werden.

Ein Schaltungsentwurfswerkzeug SEW greift für einen konkreten Schaltungsentwurf auf Standardzellen aus einer Bibliothek B zurück, die in einem Schritt S1 in das Schaltungsentwurfswerkzeug SEW geladen werden. Das Schaltungsentwurfswerkzeug SEW erstellt in einem Schritt S2 mit den Daten aus der Bibliothek B eine Schaltung S. In einem Schritt S3 wird auf Basis der eingangs genannten vereinfachten Betrachtung der Schaltung S eine Netzliste NL-S der Schaltung S erstellt, welche die Logikzellen der Schaltung und deren Verbindungen beschreibt. In einem Schritt S4 wird außerdem für jede der in der Schaltung S verwendeten SDTMR-FF- bzw. SDTMR-L-Zellen 100,400,500 eine Netzliste NL-Z erzeugt, welche die innere Struktur Z der jeweiligen Zellen 100,400,500 berücksichtigt. Für die Generierung eines Testmusters für einen Scantest der Schaltung S muss ein Schaltungsmodell vorliegen, das die interne Struktur Z der jeweiligen Speicherzelle berücksichtigt, um interne Fehler in den komplexen Speicherzellen erkennen zu können. Ein Testmustergenerierungswerkzeug TMG für die Erzeugung eines Testmusters lädt zu diesem Zweck Daten aus der Bibliothek B (Schritt S5), die Struktur der Schaltung S von dem Schaltungsentwurfswerkzeug SEW (Schritt S6) sowie die Netzliste der Schaltung NL-S (Schritt S7) und die Netzliste der SDTMR-L Zelle (Schritt S8). Mit diesen Daten erzeugt das Testmustergenerierungswerkzeug TMGT ein Testmuster TM für die zu fertigende Schaltung S mit SDTMR-Zellen.

Eine Besonderheit dieses Verfahrens besteht darin, dass sowohl die Netzliste der mit dem Schaltungsentwurfswerkzeug SE entworfenen Schaltung S als auch die Netzliste für die SDTMR-Zellen als Eingangsdaten verwendet werden, um ein geeignetes Testmuster zu erzeugen.

## Patentansprüche

1. Speicherzelle zum Speichern digitaler Daten mit mindestens drei bistabilen Speicherelementen (FF1-FF3; SFF1-SFF3; L1-L3), die in einer Normalbetriebsart ein digitales Eingangssignal und ein Taktsignal (C) empfangen, wobei jedes bistabile Speicherelement ein Ausgangssignal (Q1-Q3) an ein Majoritäts-Gate (101) abgibt, das an einem ersten Ausgang (Q) der Speicherzelle ein Ausgangssignal gemäß der Majorität der digitalen Eingangssignale erzeugt, wobei die Speicherzelle wahlweise in eine Scanbetriebsart umschaltbar ist, in welcher die bistabilen Speicherelemente (FF1-FF3; SFF1-SFF3; L1-L3) zu einem Schieberegister verbunden sind, **dadurch gekennzeichnet, dass** jedem bistabilen Speicherelement (FF1-FF3; SFF1-SFF3; L1-L3) jeweils ein 2:1-Multiplexer (MUX1-MUX3) vorgeschaltet ist, und dass die 2:1-Multiplexer abhängig von einem Aktivierungssignal (SE) entweder in der Normalbetriebsart jedem bistabilen Speicherelement das digitale Eingangssignal zuführen oder in der Scanbetriebsart die bistabilen Speicherelemente zu dem Schieberegister verbinden und dass die Speicherzelle einen zweiten Ausgang (SO) aufweist, an dem in der Scanbetriebsart das Ausgangssignal (Q3) des letzten bistabilen Speicherelements (FF3,SFF3,L3) in dem Schieberegister anliegt.

2. Speicherzelle nach Anspruch 1, **dadurch gekennzeichnet, dass** den Dateneingängen der bistabilen Speicherelemente ein Transientenfilter (SET) vorgeschaltet ist, der als Eingangssignal das digitale Eingangssignal empfängt und als Ausgangssignale mehrere Ausprägungen des Eingangssignals (D1,D2,D3) abgibt, wovon mindestens ein Ausgangssignal (D2,D3) gegenüber einem anderen Ausgangssignal (D1) zeitverzögert ist.

3. Speicherzelle nach Anspruch 2, **dadurch gekennzeichnet, dass** dem Dateneingang eines bistabilen Speicherelements (FF2,SFF2,L2) ein erstes Verzögerungselement (102) vorgeschaltet ist, und dass dem Dateneingang eines anderen bistabilen Speicherelements (FF3,SFF3,L3) ein zweites Verzögerungselement (103) vorgeschaltet ist, das eine längere Signalverzögerung bewirkt als das erste Verzögerungselement.

4. Speicherzelle nach Anspruch 3, **dadurch gekennzeichnet, dass** dem Dateneingang des in dem Schieberegister an zweiter Stelle angeordneten bistabilen Speicherelements (FF2,SFF2,L2) das erste Verzögerungselement (102) vorgeschaltet ist und dass dem Dateneingang des in dem Schieberegister an dritter Stelle angeordneten bistabilen Speicherelements (FF3,SFF3,L3) das zweite Verzögerungselement (103) vorgeschaltet ist.

5. Speicherzelle nach Anspruch 1, **dadurch gekennzeichnet, dass** der Ausgang des dem zweiten bistabilen Speicherelements (FF2,SFF2,L2) zugeordneten Multiplexers (MUX2) mit dem Eingang des ersten Verzögerungselements (102) verbunden ist und dass der Ausgang des dem dritten bistabilen Speicherelement (FF3,SFF3,L3) zugeordneten Multiplexers (MUX3) mit dem Eingang des zweiten Verzögerungselements (103) verbunden ist.

6. Speicherzelle nach Anspruch 5, **dadurch gekennzeichnet, dass** zwischen dem Ausgang des ersten bistabilen Speicherelements (FF1,SFF21,L1) des Schieberegisters, der mit einem Eingang des dem zweiten bistabilen Speicherelement (FF2,SFF2,L2) zugeordneten Multiplexers verbunden ist, ein weiteres Verzögerungselement (104) zwischengeschaltet ist, und dass zwischen dem Ausgang des zweiten bistabilen Speicherelements (FF2,SFF2,L2) des Schieberegisters, der mit einem Eingang des dem dritten bistabilen Speicherelement (FF3,SFF3,L3) zugeordneten Multiplexers (MUX3) zugeordnet ist ein weiteres Verzögerungselement (104) zwischengeschaltet ist.

7. Speicherzelle nach einem der vorstehenden Ansprüche, **dadurch gekennzeichnet, dass** die Speicherzelle drei flankengesteuerte scanfähige Flip-Flops (SFF1-SFF3) mit jeweils einem Scandateneingang (SD) als bistabile Speicherelemente aufweist, und dass den Scandateneingängen (SD) der in dem Schieberegister an zweiter Stelle und an dritter Stelle angeordneten Flip-Flops (SFF2,SFF3) ein Verzögerungselement (105) vorgeschaltet ist.

8. Speicherzelle nach Anspruch 7, **dadurch gekennzeichnet, dass** dem zweiten und dem dritten Flip-Flop (SFF2,SFF3) ein AND-Gatter (401,402) zugeordnet ist, dessen einer Eingang mit dem Ausgang des in dem Schieberegister vorhergehenden Flip-Flops und dessen anderer Eingang mit dem Aktivierungssignal (SE) verbunden ist und dass der Ausgang des AND-Gatters (401,402) direkt mit dem Scandateneingang (SD) des in dem Schieberegister dahinter geschalteten Flip-Flops (SFF2,SFF3) verbunden ist oder mit dem Eingang eines Verzögerungselements (105) verbunden ist, dessen Ausgang mit dem Scandateneingang (SD) des in dem Schieberegister dahinter geschalteten Flip-Flops (SFF2,SFF3) verbunden ist.

9. Speicherzelle nach einem der vorstehenden Ansprüche, **dadurch gekennzeichnet, dass** zwischen dem Ausgang des dritten bistabilen Speicherelements (FF3,SFF3,L3) in dem Schieberegister und dem zweiten Ausgang (SO) der Speicherzelle ein logisches Gatter (106) angeordnet ist, insbesondere ein AND-Gatter.

10. Speicherzelle nach einem der vorstehenden Ansprüche, **dadurch gekennzeichnet, dass** die bistabilen Speicherelemente als pegelgesteuerte Latches (L1-L3) ausgebildet sind, dass in der Scanbetriebsart das zweite Latch (L2) in dem Schieberegister mit einem anderen Taktsignal (TC) getaktet ist als das erste und das dritte Latch (L1,L3) in dem Schieberegister und dass der Ausgang des dritten Latches (L3) mit einem Dateneingang eines vierten Latches (L4) verbunden ist, dessen Ausgang den zweiten Ausgang (SO) der Speicherzelle bildet.

11. Speicherzelle nach Anspruch 10, **dadurch gekennzeichnet, dass** der Ausgang des dritten Latches (L3) in dem Schieberegister mit einem Eingang eines AND-Gatters (501) verbunden ist, an dessen anderen Eingang das Aktivierungssignal (SE) anliegt und dass der Ausgang des AND-Gatters (501) mit dem Dateneingang (D) des vierten Latches (L4) verbunden ist.

12. Speicherzelle nach Anspruch 10 oder 11, **dadurch gekennzeichnet, dass** vor dem Taktsignaleingang des zweiten Latches (L2) in dem Schieberegister ein 2:1-Multiplexer (MUX22) angeordnet ist, der abhängig von dem Aktivierungssignal (SE) dem zweiten Latch (L2) unterschiedliche Taktsignale (C,TC) zuführt.

13. Verfahren zur Erzeugung eines Testmusters, um eine Schaltung mit einer Speicherzelle (100,400,500) nach einem der vorstehenden Ansprüche auf Bitfehler zu prüfen, wobei das Verfahren folgende Schritte umfasst:
- Laden (S1) von Daten für Standardzellen aus einer Bibliothek (B) in ein Schaltungsentwurfswerkzeug (SEW);
- Erstellen (S2) einer Schaltung (S) auf Basis der zuvor geladenen Daten;
- Erstellen (S3) einer Netzliste (NL-S) der Schaltung;
- Erstellen (S4) einer Netzliste (NL-Z) der Speicherzelle;
- Laden (S5) von Daten für Standardzellen aus der Bibliothek (B) in ein Testmustergenerierungswerkzeug (TMG);
- Laden (S6) der Struktur der Schaltung (S) in das Testmustergenerierungswerkzeug (TMG);
- Laden (S7) der Netzliste der Schaltung (NL-S) in das Testmustergenerierungswerkzeug (TMG);
- Laden (S8) der Netzliste der Speicherzelle (NL-Z) in das Testmustergenerierungswerkzeug (TMG); und
- Erzeugen (S9) des Testmusters für die Schaltung (S).

## Claims

1. Memory cell for storing digital data with at least three bistable memory elements (FF1-FF3; SFF1-SFF3; L1-L3) which receive a digital input signal and a clock signal (C) in a normal operating mode, wherein each bistable memory element outputs an output signal (Q1-Q3) to a majority gate (101) which generates an output signal at a first output (Q) of the memory cell according to the majority of the digital input signals, wherein the memory cell is selectively switchable into a scan mode in which the bistable memory elements (FF1-FF3; SFF1-SFF3; L1-L3) are connected to form a shift register, **characterized in that** each bistable memory element (FF1-FF3; SFF1-SFF3; L1-L3) is preceded by a 2:1 multiplexer (MUX1-MUX3), and **in that** the 2:1 multiplexers, depending on an activation signal (SE), either supply the digital input signal to each bistable memory element in the normal operating mode or connect the bistable memory elements to the shift register in the scan mode, and **in that** the memory cell has a second output (SO), to which the output signal (Q3) of the last bistable memory element (FF3,SFF3,L3) in the shift register is present in the scan mode.

2. Memory cell according to claim 1, **characterized in that** a transient filter (SET) is connected upstream of the data inputs of the bistable memory elements, which transient filter receives the digital input signal as input signal and outputs several variations of the input signal (D1,D2,D3) as output signals, of which at least one output signal (D2, D3) is delayed with respect to another output signal (D1).

3. Memory cell according to claim 2, **characterized in that** a first delay element (102) is connected upstream of the data input of a bistable memory element (FF2,SFF2,L2), and **in that** a second delay element (103) is connected upstream of the data input of another bistable memory element (FF3,SFF3,L3), which causes a longer signal delay than the first delay element.

4. Memory cell according to claim 3, **characterized in that** the first delay element (102) is connected upstream of the data input of the bistable memory element (FF2,SFF2,L2) arranged in the second position in the shift register and that the second delay element (103) is connected upstream of the data input of the bistable memory element (FF3,SFF3,L3) arranged in the third position in the shift register.

5. Memory cell according to claim 1, **characterized in that** the output of the multiplexer (MUX2) assigned to the second bistable memory element (FF2,SFF2,L2) is connected to the input of the first delay element (102) and that the output of the multiplexer (MUX3) assigned to the third bistable memory element (FF3,SFF3,L3) is connected to the input of the second delay element (103).

6. Memory cell according to claim 5, **characterized in that** between the output of the first bistable memory element (FF1,SFF21,L1) of the shift register, which is connected to an input of the multiplexer associated with the second bistable memory element (FF2,SFF2,L2), a further delay element (104) is interposed, and that a further delay element (104) is interposed between the output of the second bistable memory element (FF2,SFF2,L2) of the shift register, which is associated with an input of the multiplexer (MUX3) associated with the third bistable memory element (FF3,SFF3,L3).

7. Memory cell according to any one of the preceding claims, **characterized in that** the memory cell has three edge-triggered scan-capable flip-flops (SFF1-SFF3), each with a scan data input (SD), as bistable memory elements, and **in that** a delay element (105) is connected upstream of the scan data inputs (SD) of the flip-flops (SFF2,SFF3) arranged in the second position and in the third position in the shift register.

8. Memory cell according to claim 7, **characterized in that** the second and the third flip-flop (SFF2, SFF3) are assigned an AND gate (401, 402), one input of which is connected to the output of the flip-flop preceding it in the shift register and the other input of which is connected to the activation signal (SE), and **in that** the output of the AND gate (401, 402) is connected directly to the scan data input (SD) of the flip-flop (SFF2,SFF3) connected downstream in the shift register or is connected to the input of a delay element (105) whose output is connected to the scan data input (SD) of the flip-flop (SFF2,SFF3) connected downstream in the shift register.

9. Memory cell according to any one of the preceding claims, **characterized in that** a logic gate (106), in particular an AND gate, is arranged between the output of the third bistable memory element (FF3, SFF3, L3) in the shift register and the second output (SO) of the memory cell.

10. Memory cell according to any one of the preceding claims, **characterized in that** the bistable memory elements are designed as level-controlled latches (L1-L3), that in the scan mode the second latch (L2 ) in the shift register is clocked with a different clock signal (TC) than the first and the third latch (L1, L3) in the shift register and that the output of the third latch (L3) is connected to a data input of a fourth latch (L4), the output of which forms the second output (SO) of the memory cell.

11. Memory cell according to claim 10, **characterized in that** the output of the third latch (L3) in the shift register is connected to an input of an AND gate (501), to whose other input the activation signal (SE) is applied and **in that** the output of the AND gate (501) is connected to the data input (D) of the fourth latch (L4).

12. Memory cell according to claim 10 or 11, **characterized in that** a 2:1 multiplexer (MUX22) is arranged in the shift register before the clock signal input of the second latch (L2), which multiplexer supplies different clock signals (C, TC) to the second latch (L2) depending on the activation signal (SE).

13. Method for generating a test pattern to test a circuit having a memory cell (100, 400, 500) according to any one of the preceding claims for bit errors, the method comprising the following steps:
- loading (S1) data for standard cells from a library (B) into a circuit design tool (SEW);
- creating (S2) a circuit (S) based on the previously loaded data;
- creating (S3) a netlist (NL-S) of the circuit;
- creating (S4) a netlist (NL-Z) of the memory cell;
- loading (S5) data for standard cells from the library (B) into a test pattern generation tool (TMG);
- loading (S6) the structure of the circuit (S) into the test pattern generation tool (TMG);
- loading (S7) the netlist of the circuit (NL-S) into the test pattern generation tool (TMG);
- loading (S8) the netlist of the memory cell (NL-Z) into the test pattern generation tool (TMG); and
- generating (S9) the test pattern for the circuit (S).

## Revendications

1. Cellule de mémoire pour le stockage de données numériques avec au moins trois éléments de mémoire bistables (FF1-FF3 ; SFF1-SFF3 ; L1-L3) qui, en mode de fonctionnement normal, reçoivent un signal d'entrée numérique et un signal d'horloge (C), chaque élément de mémoire bistable délivrant un signal de sortie (Q1-Q3) à une porte majoritaire (101) qui génère un signal de sortie sur une première sortie (Q) de la cellule de mémoire en fonction de la majorité des signaux d'entrée numériques, la cellule de mémoire pouvant être commutée au choix dans un mode de fonctionnement de balayage dans lequel les éléments de mémoire bistables (FF1-FF3 ; SFFI-SFF3 ; L1-L3) sont connectés à un registre à décalage, **caractérisé en ce que** chaque élément de mémoire bistable (FF1-FF3 ; SFF1-SFF3 ; L1-L3) est précédé d'un multiplexeur (MUXI -MUX3) et que les multiplexeurs 2:1, en fonction d'un signal d'activation (SE), soit fournissent le signal d'entrée numérique à chaque élément de mémoire bistable en mode de fonctionnement normal, soit relient les éléments de mémoire bistables au registre à décalage en mode de fonctionnement de balayage, et que la cellule de mémoire présente une deuxième sortie (S0) à laquelle le signal de sortie (Q3) du dernier élément de mémoire bistable (FF3, SFF3, L3) est appliqué dans le registre à décalage en mode de fonctionnement de balayage.

2. Cellule de mémoire selon la revendication 1, **caractérisée par le fait qu'**un filtre transitoire (SET) est connecté en amont des entrées de données des éléments de mémoire bistables, qui reçoit le signal d'entrée numérique en tant que signal d'entrée et délivre plusieurs formes du signal d'entrée (D1, D2, D3) en tant que signaux de sortie, dont au moins un signal de sortie (D2, D3) est retardé par rapport à un autre signal de sortie (D1).

3. Cellule de mémoire selon la revendication 2, **caractérisée en ce qu'**un premier élément de retard (102) est connecté en amont de l'entrée de données d'un élément de mémoire bistable (FF2, SFF2, L2) et **en ce qu'**un deuxième élément de retard (103) est connecté en amont de l'entrée de données d'un autre élément de mémoire bistable (FF3, SFF3, L3), ce qui provoque un retard de signal plus long que le premier élément de retard.

4. Cellule de mémoire selon la revendication 3, **caractérisée par le fait que** le premier élément de retard (102) est connecté en amont de l'entrée de données de l'élément de mémoire bistable (FF2, SFF2, L2) disposé en deuxième position dans le registre à décalage et que le deuxième élément de retard (103) est connecté en amont de l'entrée de données de l'élément de mémoire bistable (FF3, SFF3, L3) disposé en troisième position dans le registre à décalage.

5. Cellule de mémoire selon la revendication 1, **caractérisée en ce que** la sortie du multiplexeur (MUX2) associé au deuxième élément de mémoire bistable (FF2, SFF2, L2) est connectée à l'entrée du premier élément de retard (102) et **en ce que** la sortie du multiplexeur (MUX3) associé au troisième élément de mémoire bistable (FF3, SFF3, L3) est connectée à l'entrée du deuxième élément de retard (103).

6. Cellule de mémoire selon la revendication 5, **caractérisée en ce qu'**un autre élément de retard (104) est interposé entre la sortie du premier élément de mémoire bistable (FF1, SFF21, L1) du registre à décalage, qui est connecté à une entrée du multiplexeur associé au deuxième élément de mémoire bistable (FF2, SFF2, L2), et **en ce qu'**un autre élément de retard (104) est interposé entre la sortie du deuxième élément de mémoire bistable (FF2, SFF2, L2) du registre à décalage, qui est associé à une entrée du multiplexeur (MUX3) associé au troisième élément de mémoire bistable (FF3, SFF3, L3).

7. Cellule de mémoire selon l'une des revendications précédentes, **caractérisée en ce que** la cellule de mémoire comporte trois bascules à commande par front (SFF1-SFF3) avec chacune une entrée de données de balayage (SD) comme éléments de mémoire bistables, et **en ce qu'**un élément de retard (105) est connecté en amont des entrées de données de balayage (SD) des bascules (SFF2, SFF3) disposées en deuxième et en troisième position dans le registre à décalage.

8. Cellule de mémoire selon la revendication 7, **caractérisée en ce qu'**une porte ET (401, 402) est affectée à la deuxième et à la troisième bascule (SFF2, SFF3), dont une entrée est connectée à la sortie de la bascule précédente dans le registre à décalage et dont l'autre entrée est connectée au signal d'activation (SE) et **en ce que** la sortie de la porte ET (401, 402) est connectée directement à l'entrée de données de balayage (SD) de la bascule (SFF2, SFF3) connectée derrière dans le registre à décalage ou à l'entrée d'un élément de retard (105) dont la sortie est connectée à l'entrée de données de balayage (SD) de la bascule (SFF2, SFF3) connectée derrière dans le registre à décalage.

9. Cellule de mémoire selon l'une des revendications précédentes, **caractérisée en ce qu'**une porte logique (106), en particulier une porte ET, est disposée entre la sortie du troisième élément de mémoire bistable (FF3, SFF3, L3) dans le registre à décalage et la deuxième sortie (S0) de la cellule de mémoire.

10. Cellule de mémoire selon l'une des revendications précédentes, **caractérisée en ce que** les éléments de mémoire bistables sont conçus comme des verrous à commande de niveau (L1-L3), **en ce que**, dans le mode de fonctionnement à balayage, le deuxième verrou (L2) dans le registre à décalage est cadencé avec un signal d'horloge (TC) différent du premier et du troisième verrou (L1, L3) dans le registre à décalage, et **en ce que** la sortie du troisième verrou (L3) est connectée à une entrée de données d'un quatrième verrou (L4) dont la sortie forme la deuxième sortie (S0) de la cellule de mémoire.

11. Cellule de mémoire selon la revendication 10, **caractérisée en ce que** la sortie du troisième verrou (L3) dans le registre à décalage est connectée à une entrée d'une porte ET (501) à l'autre entrée de laquelle le signal d'activation (SE) est appliqué et **en ce que** la sortie de la porte ET (501) est connectée à l'entrée de données (D) du quatrième verrou (L4).

12. Cellule de mémoire selon la revendication 10 ou 11, **caractérisée en ce qu'**un multiplexeur 2:1 (MUX22) est disposé dans le registre à décalage avant l'entrée du signal d'horloge du deuxième verrou (L2), qui, en fonction du signal d'activation (SE), fournit au deuxième verrou (L2) différents signaux d'horloge (C, TC).

13. Procédé de génération d'un motif de test pour tester un circuit avec une cellule de mémoire (100, 400, 500) selon l'une des revendications précédentes pour les erreurs sur les bits, le procédé comprenant les étapes suivantes :
- Chargement (SI) de données pour des cellules standard d'une bibliothèque (B) dans un outil de conception de circuit (SEW) ;
- Création (S2) d'un circuit (S) basé sur les données précédemment chargées ;
- Création (S3) d'une liste de réseau (NL-S) du circuit ;
- Création (S4) d'une liste de réseau (NL-Z) de la cellule de mémoire ;
- Chargement (S5) de données pour cellules standard de la bibliothèque (B) dans un outil de génération de motifs de test (TMG) ;
- Chargement (S6) de la structure du circuit (S) dans l'outil de génération de modèle de test (TMG) ;
- Chargement (S7) de la liste de connexion du circuit (NL-S) dans l'outil de génération de modèle de test (TMG) ;
- Chargement (S8) de la liste de connexion de la cellule de mémoire (NL-Z) dans l'outil de génération de modèle de test (TMG) ; et
- Création (S9) du motif de test pour le circuit (S).
